# DEMANDE DE BREVET EUROPEEN

(11) **EP 1 406 359 A1**
(43) Date de publication de la demande: **07.04.2004**
(21) Numéro de dépôt: 03292366.6
(22) Date de dépôt: 26.09.2003
(51) Int. Cl.: H01S 5/06, H01S 5/0683, H01S 5/062

(54) **Procédé de reglage d'un emetteur laser et equipement optique correspondant**

(30) Priorité: 01.10.2002 FR 0212111
(71) Demandeur: Sagem SA, 75015 Paris (FR)
(72) Inventeur: Bonnet, Yvan, 22700 Perros Guirec (FR); Lossouarn, Yann, 91300 Massy (FR); Polaillon, Quoin-Lan, 75015 Paris (FR)
(74) Mandataire: Fruchard, Guy

(57) **Abrégé**

Le procédé de réglage d'un émetteur laser (3) propre à émettre un faisceau laser modulé comporte les étapes de déterminer au moins une puissance requise différente d'une puissance nominale et d'effectuer un réglage d'un paramètre d'alimentation de l'émetteur laser de façon à obtenir la puissance requise.

## Description

La présente invention concerne un procédé de réglage d'un émetteur laser et une carte optique correspondante.

### ARRIERE PLAN DE L'INVENTION

On connaît des systèmes de transmission sous forme de signal optique modulé, parmi lesquels le système appelé WDM. Par référence à la longueur d'onde du signal porteur, le signal individuel modulé est généralement dénommé « une longueur d'onde ».

La transmission du signal optique modulé est assurée par un réseau ayant généralement une configuration en anneau ou une configuration linéaire.

Le réseau comporte en outre des récepteurs qui ne peuvent fonctionner de façon satisfaisante que si ils sont disposés par rapport à l'émetteur dans une plage de distances déterminée par l'atténuation résultant des équipements assurant la transmission et de la ligne assurant la liaison entre ces équipements.

Les équipements optiques existants sont équipés d'un émetteur laser réglé à une puissance nominale. L'équipement livré à un opérateur est donc choisi en fonction de la portée souhaitée, ce qui implique des frais de fabrications élevés en raison de la diversité des équipements à fabriquer, et des coûts de stockage importants en raison de la nécessité de conserver un nombre élevé d'équipements correspondant à chaque portée.

Par ailleurs, dans le cas d'un regroupement par multiplexage d'une série de signaux individuels chacun modulé à partir d'un signal porteur à une longueur d'onde déterminée on sait qu'il est nécessaire pour les amplifier que toutes les longueurs d'ondes soient transmises avec une puissance optique sensiblement identique. Dans les équipements existants l'égalité de puissance des signaux est obtenue en disposant un atténuateur optique variable agissant sur la longueur d'onde pour en diminuer la puissance de façon correspondante à un écart avec la longueur d'onde qui a la puissance la plus faible. La nécessité de disposer des atténuateurs optiques sur chaque longueur d'onde augmente de façon importante le coût des équipements.

### BREVE DESCRIPTION DE L'INVENTION

Selon l'invention on prévoit un procédé de réglage d'un émetteur laser propre à émettre un faisceau lumineux modulé selon un taux de modulation en vue d'une transmission dans un réseau, ce procédé comportant les étapes de déterminer au moins une puissance requise différente d'une puissance nominale et d'effectuer un réglage d'un paramètre d'alimentation de l'émetteur laser de façon à obtenir la puissance requise.

Ainsi, en équipant tous les équipements avec un laser de grande portée et en réglant la puissance effective selon la portée désirée il est possible de diminuer le nombre d'équipements différents tout en couvrant l'ensemble des gammes de portée habituellement recherchées.

En outre, lorsque l'on souhaite tester un équipement conventionnel, c'est-à-dire une carte dont le laser est réglé de façon définitive à la puissance nominale, il est nécessaire de disposer d'une ligne de test ayant une longueur égale à la portée minimale correspondante. En utilisant le procédé selon l'invention il est envisageable de ramener la puissance de l'émetteur à une valeur très faible correspondant à une portée voisine de zéro de sorte qu'il serait alors possible d'utiliser une ligne de test très courte pour tester l'équipement. La maintenance des équipements et la recherche des pannes en seraient donc facilitées.

Selon une version avantageuse de l'invention le procédé comporte en outre les étapes de déterminer en atelier une correspondance entre des valeurs du paramètre d'alimentation et des valeurs correspondantes de la puissance du faisceau lumineux émis, et utiliser cette correspondance lors du réglage de l'émetteur. On s'assure ainsi que le réglage effectué par une variation du paramètre d'alimentation conduit bien à la valeur de puissance requise.

Selon encore un aspect avantageux de l'invention le procédé comporte en outre l'étape d'adapter le taux de modulation préalablement au réglage du paramètre d'alimentation. On s'assure ainsi que le taux de modulation n'interfère pas avec le réglage de la puissance.

De préférence le taux de modulation est également adapté après le réglage du paramètre d'alimentation. On s'assure ainsi que l'on adopte le taux de modulation optimum en fonction de la puissance à laquelle l'émetteur est réglé.

L'invention concerne également un équipement optique mettant en oeuvre le procédé selon l'invention et comportant à cet effet un émetteur laser propre à émettre un faisceau lumineux, des moyens pour réaliser une modulation du faisceau lumineux, des moyens de réglage d'au moins un paramètre d'alimentation de l'émetteur laser et des moyens établissant une correspondance entre des valeurs du paramètre d'alimentation et des valeurs de puissance correspondante du faisceau lumineux. Indépendamment du réglage de départ effectué en atelier il est ainsi possible d'effectuer aisément un réglage précis de l'émetteur selon une puissance requise.

De préférence les moyens de réglage sont des moyens logiciels, et les moyens établissant la correspondance entre des variations du paramètre d'alimentation et des variations de puissance correspondante sont mémorisés dans la carte, de préférence sous forme d'une table. Le réglage du laser peut alors être effectué de façon totalement informatisée, ce qui permet en particulier un réglage à distance.

### BREVE DESCRIPTION DES DESSINS

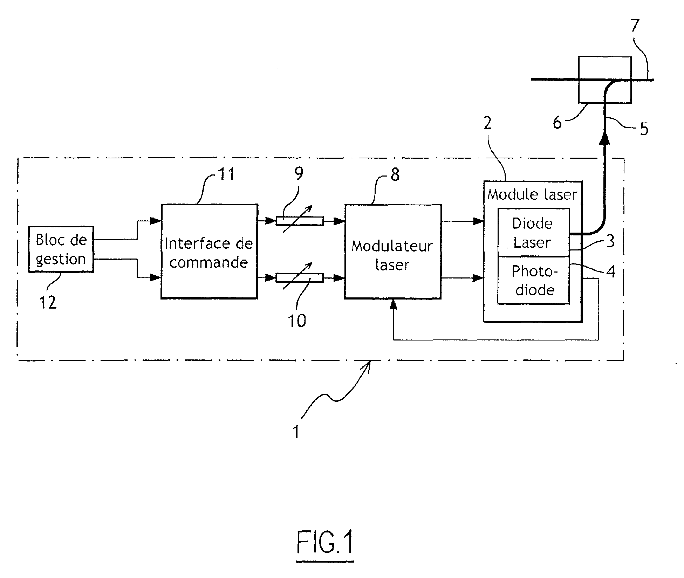

D'autres caractéristiques et avantages de l'invention apparaîtront à la lecture de la description qui suit en relation avec la figure unique ci-jointe qui est une représentation schématique par blocs d'une carte selon l'invention et de sa liaison avec un réseau.

### DESCRIPTION DETAILLEE DE L'INVENTION

En référence à la figure, l'équipement optique 1 symbolisé par un trait mixte sur la figure comprend un module laser 2 comprenant une diode laser 3 associée à une photodiode 4 la sortie du module laser est reliée par une ligne 5 à un organe d'injection 6 dans un réseau 7 partiellement représenté sur la figure.

Le module laser 2 comporte deux entrées respectivement reliées à des sorties d'un modulateur laser 8 ayant une entrée reliée à la sortie de la photodiode 4 et deux entrées respectivement reliées à un élément variable 9 correspondant à la modulation et un élément variable 10 correspondant à la puissance. Les éléments variables 9 et 10 sont reliés à une interface de commande 11 elle-même reliée à un bloc de gestion 12.

Lors du réglage initial de l'équipement en atelier une consigne de puissance optique moyenne et une consigne de taux de modulation sont mémorisés dans le bloc de gestion 12 ainsi qu'une table de correspondance entre les valeurs d'un paramètre d'alimentation du laser, par exemple les valeurs d'un courant d'alimentation, et des valeurs correspondantes de la puissance moyenne du laser. On notera à ce propos que la courbe caractéristique de la puissance moyenne en fonction du courant d'alimentation est théoriquement linéaire mais ne l'est pas dans la réalité de sorte qu'il est préférable de déterminer une table de correspondance propre à chaque laser en s'aidant des données fournies par le fabricant du laser.

En atelier les éléments variables 9 et 10 sont également réglés pour obtenir à la sortie du module laser des valeurs correspondantes aux valeurs de consigne initiales. Par exemple pour un laser ayant une puissance de crête de 10 mW fonctionnant à une longueur d'onde de 1550 nm la carte est réglée pour délivrer un signal de sortie ayant une puissance moyenne de 7 dBm et un taux de modulation correspondant. Pour une atténuation de ligne comprises entre 0,2 dB/km et 0,25 dB/km, ce réglage correspond à une portée comprise entre environ 76 et 124 kilomètres.

Selon l'invention il est également possible avec le même équipement et, sans qu'il soit nécessaire d'utiliser un atténuateur optique, d'obtenir une portée comprise entre environ 60 et 108 kilomètres. A cet effet la consigne de modulation est tout d'abord abaissée pour correspondre à un taux de modulation inférieur à celui utilisé lorsque la puissance du laser est égale à 3 dBm. La nouvelle consigne de taux de modulation est transmise par l'interface de commande à l'élément variable 9 qui agit sur le modulateur laser. La consigne de puissance est alors elle-même ramenée à 3 dBm et l'interface de commande 11 agit sur l'élément variable 10 pour amener le paramètre d'alimentation à une valeur correspondante à la puissance requise. Le module laser est automatiquement réglé à cette puissance par l'action de la photodiode 4 et la boucle de régulation qui relie la photodiode 4 au modulateur laser 8. Lorsque la puissance requise est atteinte une nouvelle consigne de taux de modulation est envoyée pour ramener le taux de modulation à la valeur optimale correspondant à la puissance requise du laser. Ces différentes étapes sont de préférence réalisées au moyen d'un logiciel mémorisé dans le bloc de gestion. Pendant cette étape de réglage de la portée du laser le bloc de gestion est de préférence relié à un ordinateur permettant d'afficher des choix possibles de la portée et permettant à l'opérateur d'effectuer une sélection de la portée souhaitée.

De la même manière on peut prévoir pour des portées courtes un équipement comprenant un laser de puissance crête de 2 mW fonctionnant à une longueur d'onde de 1310 nm réglé initialement à une puissance moyenne de 0 dBm et pouvant être réglé par une alimentation appropriée à une puissance moyenne de -10 dBm, les portées correspondantes étant de l'ordre de 30 à 60 kilomètres d'une part et de l'ordre de 0 à 35 kilomètres d'autre part.

On remarquera qu'avec deux équipements différents seulement on couvre alors une portée de 0 à 124 kilomètres.

Dans le cas d'un multiplexage d'une série de longueurs d'onde, les blocs de gestion associés à chaque longueur d'onde sont de préférence reliés à une unité de traitement commune qui comporte des moyens de comparaison des puissances moyennes de chaque longueur d'onde et qui déterminent les consignes de puissance devant être envoyées par chaque bloc de gestion afin qu'à l'issue du réglage les différentes longueur d'ondes soient toutes à une même puissance moyenne.

Bien entendu l'invention n'est pas limitée aux modes de mise en oeuvre décrits et on peut y apporter des variantes de réalisation sans sortir du cadre de l'invention tel que défini par les revendications. En particulier, bien que l'invention ait été décrite en relation avec des réglages de portée correspondant à la puissance nominale et seulement une puissance requise différente de la puissance nominale, on peut prévoir de multiplier les puissances intermédiaires pour permettre d'adapter la carte à des configurations variées de réseau.

Dans le cas d'un multiplexage et d'une série de longueur d'ondes le procédé selon l'invention pourra être également utilisé pour la mise en oeuvre du procédé de régulation de puissance d'au moins une longueur d'ondes entrante tel que décrit dans le document FR-A-2 812 485.

Dans le cas du réglage de portée d'une seule longueur d'onde on pourra également prévoir un organe de réglage manuel du courant d'alimentation, monté en façade de l'équipement portant la carte.

Bien que l'invention ait été décrite en utilisant des moyens de réglage sous forme d'un logiciel associé à une table de correspondance, on peut prévoir un réglage au moyen d'un algorithme ou même d'un circuit comportant des moyens physiques de réglage. L'équipement optique 1 peut comprendre une carte unique portant tous les composants, ou des composants montés sur des supports séparés et reliés entre eux de façon appropriée.

## Revendications

1. Procédé de réglage d'un émetteur laser (3) propre à émettre un faisceau lumineux modulé selon un taux de modulation en vue d'une transmission dans un réseau (7) **caractérisé en ce que** le procédé comporte les étapes de déterminer au moins une puissance requise différente d'une puissance nominale, et d'effectuer un réglage d'un paramètre d'alimentation de l'émetteur laser de façon à obtenir la puissance requise.

2. Procédé selon la revendication 1, **caractérisé en ce qu'**il comporte en outre les étapes de déterminer en atelier une correspondance entre des valeurs du paramètre d'alimentation et des valeurs correspondantes de la puissance du faisceau lumineux émis et utiliser cette correspondance lors du réglage de l'émetteur.

3. Procédé selon la revendication 1, **caractérisé en ce qu'**il comporte en outre des étapes d'adapter le taux de modulation préalablement au réglage du paramètre d'alimentation.

4. Procédé selon la revendication 1, **caractérisé en ce qu'**il comporte en outre l'étape d'adapter le taux de modulation après le réglage du paramètre d'alimentation.

5. Equipement optique comportant un émetteur laser (3) propre à émettre un faisceau lumineux, des moyens (8) pour réaliser une modulation du faisceau lumineux, et des moyens de réglage (10) d'au moins un paramètre d'alimentation de l'émetteur laser **caractérisé en ce qu'**il comporte des moyens (12) établissant une correspondance entre des valeurs du paramètre d'alimentation et des valeurs de puissance correspondantes du faisceau lumineux.

6. Equipement selon la revendication 5, **caractérisé en ce que** les moyens de réglage sont des moyens logiciels et **en ce que** les moyens établissant la correspondance entre les valeurs du paramètre d'alimentation et les valeurs de puissance correspondantes sont mémorisés dans l'équipement.

7. Equipement selon la revendication 6, **caractérisé en ce que** la correspondance entre les valeurs du paramètre d'alimentation et les valeurs de puissance est mémorisée sous forme d'une table.

8. Equipement selon la revendication 6, **caractérisé en ce qu'**il comporte en outre des moyens de mémorisation de taux de modulation associés aux valeurs de puissance.
